# EUROPEAN PATENT APPLICATION

(11) **EP 4 549 056 A1**
(43) Date of publication of application: **07.05.2025**
(21) Application number: 24208343.4
(22) Date of filing: 23.10.2024
(51) Int. Cl.: B22F 7/06, B22F 7/08, B22F 10/14, B33Y 10/00, B33Y 80/00, C22C 1/04, F28F 3/04, F28F 3/12, F28F 13/00, H01L 21/48, H01L 23/373, H01L 23/473, B22F 3/11, B22F 3/22

(54) **METHOD OF MANUFACTURING BONDED BODY, BONDED BODY, AND HEAT SINK**

(30) Priority: 02.11.2023 JP 2023188851; 04.06.2024 JP 2024090999; 04.09.2024 JP 2024152036
(71) Applicant: Ricoh Company, Ltd., Tokyo 143-8555 (JP)
(72) Inventor: SUN, Yunsheng, Tokyo, 143-8555 (JP); YAMAGUCHI, Daichi, Tokyo, 143-8555 (JP); FUKASE, Yasushi, Tokyo, 143-8555 (JP); TSUJI, Masato, Tokyo, 143-8555 (JP)
(74) Representative: SSM Sandmair

(57) **Abstract**

A method of manufacturing a bonded body includes heating a sintered body (3) while the sintered body (3) is in direct contact with an object (4) to bond the object with the sintered body (3) to obtain the bonded body.

## Description

### BACKGROUND

### Technical Field

Embodiments of the present disclosure relate to a method of manufacturing a bonded body, a bonded body, and a heat sink.

### Related Art

In the related art, various methods such as brazing, friction stir welding, laser welding, and diffusion bonding have been used for bonding members containing metals. For example, Japanese Patent No. 6218903 discloses a method for manufacturing a bonded body that bonds an aluminum rolled plate.

### Technical Problem

An object of the present disclosure is to provide a bonded body having a good quality of bonding.

### SUMMARY

According to an embodiment of the present disclosure, a method of manufacturing a bonded body includes heating a sintered body while the sintered body is in direct contact with an object to bond the object with the sintered body to obtain the bonded body.

According to an embodiment of the present disclosure, a bonded body includes a sintered body including an alloy, and a crystal grain surrounded by a eutectic portion and an object to be directly bonded to the sintered body. The crystal grain having an average diameter of 10 µm or more;

According to an embodiment of the present disclosure, a heat sink includes the bonded body.

### BRIEF DESCRIPTION OF THE DRAWINGS

FIG. 1 is a flowchart of a method of manufacturing a bonded body according to a first embodiment of the present disclosure;
FIG. 2 is a schematic diagram of a fabricating system that produces a sintered body used in a method of manufacturing a bonded body according to an embodiment of the present disclosure;
FIG. 3 is a schematic diagram of a fabricating apparatus that produces a precursor used in a method of manufacturing a bonded body according to an embodiment of the present disclosure;
FIG. 4 is a schematic diagram of a controller of a fabricating apparatus that produces a precursor used in a method of manufacturing a bonded body according to an embodiment of the present disclosure;
FIG. 5 is a schematic diagram of a cross-sectional optical microscopic photograph of a sintered body used in the method of manufacturing a bonded body according to the first embodiment of the present disclosure;
FIG. 6 is a diagram illustrating a bonded body according to an embodiment of the present disclosure;
FIG. 7 is a schematic diagram of a cross-sectional optical microscopic photograph around a bonded boundary of a bonded body according to an embodiment of the present disclosure;
FIG. 8 is a schematic diagram of a cross-sectional optical microscopic photograph of an object according to an embodiment of the present disclosure;
FIG. 9 is a diagram illustrating another bonded body according to an embodiment of the present disclosure;
FIG. 10 is a flowchart of a method of manufacturing a bonded body according to a second embodiment of the present disclosure;
FIG. 11 is a diagram illustrating a bonded body according to an embodiment of the present disclosure;
FIG. 12 is a schematic diagram of a cross-sectional optical microscopic photograph around a bonded boundary of a bonded body bonding a sintered body and an object, according to an embodiment of the present disclosure;
FIG. 13 is a schematic diagram of a cross-sectional optical microscopic photograph around a bonded boundary of a bonded body bonding sintered bodies, according to an embodiment of the present disclosure;
FIG. 14 is a schematic diagram of a cross-sectional optical microscopic photograph around a bonded boundary of a bonded body bonding sintered bodies, according to a second embodiment of the present disclosure;
FIG. 15 is a flowchart of a method of manufacturing a bonded body according to a third embodiment of the present disclosure;
FIG. 16 is a flowchart of a method of manufacturing a bonded body according to a fourth embodiment of the present disclosure;
FIG. 17 is a diagram illustrating an object used in the method of manufacturing a bonded body according to the fourth embodiment of the present disclosure;
FIG. 18 is a cross-sectional view of the bonded body illustrated in FIG. 17 bonding a sintered body to the object;
FIG. 19 is a diagram illustrating anther object used in the method of manufacturing a bonded body according to the fourth embodiment of the present disclosure;
FIG. 20 is a diagram illustrating still another object used in the method of manufacturing a bonded body according to the fourth embodiment of the present disclosure;
FIG. 21 is a cross-sectional view of the bonded body illustrated in FIG. 20 bonding a sintered body to the object;
FIG. 22 is a diagram illustrating a container and a cover before bonding in the bonded body according to the fourth embodiment of the present disclosure;
FIG. 23 is a diagram illustrating the container and the cover after bonding in the bonded body illustrated in FIG. 22;
FIG. 24 is a flowchart of a method of manufacturing a bonded body according to a fifth embodiment of the present disclosure;
FIG. 25 is a diagram illustrating the bonded body according to the fifth embodiment of the present disclosure;
FIG. 26 is an enlarged view of a sintered body according to an embodiment of the present disclosure;
FIG. 27 is a diagram illustrating a bonded body according to a first modification of the present disclosure;
FIG. 28 is a diagram illustrating a bonded body according to a second modification of the present disclosure;
FIG. 29A is a diagram illustrating a bonded body and a sintered body according to a third modification of the present disclosure;
FIG. 29B is a diagram illustrating the sintered body according to the third modification of the present disclosure; and
FIG. 30 is a schematic diagram of a cross-sectional optical microscopic photograph around a bonded boundary of another bonded body according to an embodiment of the present disclosure.

The accompanying drawings are intended to depict embodiments of the present disclosure and should not be interpreted to limit the scope thereof. The accompanying drawings are not to be considered as drawn to scale unless explicitly noted. Also, identical or similar reference numerals designate identical or similar components throughout the several views.

### DETAILED DESCRIPTION

In describing embodiments illustrated in the drawings, specific terminology is employed for the sake of clarity. However, the disclosure of this specification is not intended to be limited to the specific terminology so selected and it is to be understood that each specific element includes all technical equivalents that have a similar function, operate in a similar manner, and achieve a similar result.

Referring now to the drawings, embodiments of the present disclosure are described below. As used herein, the singular forms "a," "an," and "the" are intended to include the plural forms as well, unless the context clearly indicates otherwise.

According to an embodiment of the present disclosure, a bonded body having a good quality of bonding can be provided.

Embodiments of the present disclosure will be described below with reference to the drawings. In the drawings, the same or like reference numerals are given to the same or corresponding parts, and the description thereof may be omitted.

### Manufacturing Method of Bonded Body

### First Embodiment

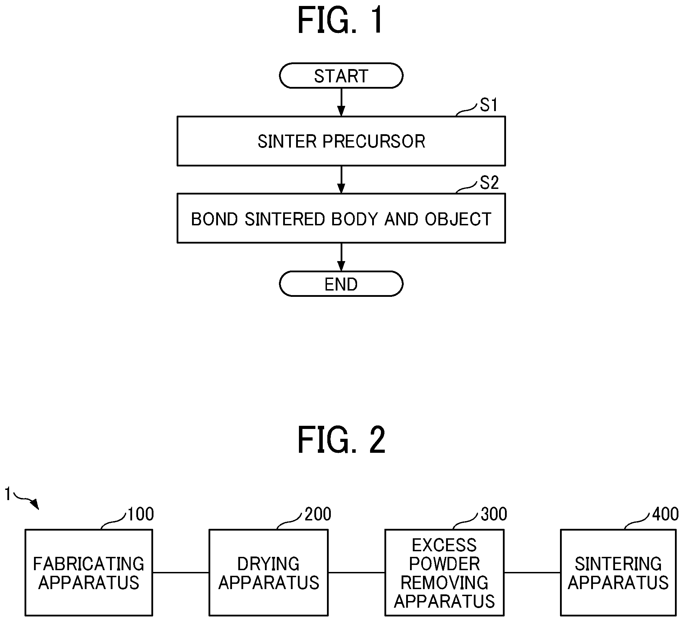

An example of a method of manufacturing a bonded body according to a first embodiment of the present disclosure and a fabricating system and a fabricating apparatus used in the method of manufacturing a bonded body according to the present embodiment will be described with reference to FIGS. 1 to 4.

FIG. 1 is a flowchart of the method of manufacturing a bonded body according to the first embodiment. The method of manufacturing a bonded body according to the first embodiment of the present disclosure includes a bonding step. The method of manufacturing a bonded body according to the first embodiment includes a sintering step before the bonding step.

In the sintering step, a sintered body is obtained. In the sintering step, for example, there is a method for obtaining a sintered body by sintering a precursor. In the sintering step, a fabricated object including powder or a green body formed by pressing powder is heated at a temperature equal to or less than a melting point of a component of the powder. The sintering step is performed in a sintering step S1 illustrated in FIG. 1.

The sintered body is obtained by sintering a precursor. The sintered body contains an alloy. In the present specification, the "sintered body" includes an alloy and preferably a crystal grain having an average diameter of 10 micrometers (µm) or more. The crystal grain is preferably covered with a eutectic portion. A "rolled body" is a product fabricated by rolling a metal object formed by sintering or casting. However, since the average diameter of the crystal grain becomes small due to the subsequent rolling process even if the rolled body is sintered, such a rolled body is not a sintered body.

The elements contained in the alloy are not particularly limited, but may be a combination of two or more metal elements or a combination of one or more metal elements and one or more nonmetal elements. The metal element contained in the alloy is a metal element selected from, for example, aluminum (Al), iron (Fe), titanium (Ti), copper (Cu), silver (Ag), gold (Au), magnesium (Mg), calcium (Ca), or zinc (Zn). Preferably, the alloy is an Al alloy. Preferably, the Al alloy is an AlSi alloy or an AlSiMg alloy.

The precursor is a formed body (i.e., green body) before sintering, which is sintered into a sintered body by sintering. The precursor includes powder. The powder included in the precursor contains two or more elements, and at least one of the two or more elements is a metal element.

The precursor may include either a mixture of a powder containing single elemental or an alloy powder. In consideration of the accuracy of the bonded body, it is more preferable that the two or more elements contained in the precursor are elements constituting the Al alloy.

The particle diameter of the powder included in the precursor is not particularly limited, but is preferably 1 µm or more and 500 µm or less, more preferably 3 µm or more and 200 µm or less, and still more preferably 5 µm or more and 100 µm or less. The particle diameter is an average particle diameter defined by a median diameter (d50).

The particle diameter of the powder included in the precursor is determined in consideration of the ease of densification in the sintering step and the handling property in producing the precursor. For example, in the case of an additive manufacturing method, the particle diameter of the powder is determined depending on the easiness of forming a powder layer.

The precursor may be produced by any method. As a producing method for the precursor, for example, an additive manufacturing method, a press molding method, a metal injection molding (MIM) method, or a casting molding method can be used.

The additive manufacturing method is a method of producing a three-dimensional (3D) fabricated object or a 3D fabricated article by laminating powder layers containing powder using a 3D printer. The fabricated object obtained by the additive manufacturing method is referred to as a green body. The green body is an example of the precursor.

In a press molding method, a mold is filled with powder, and a movable mold presses the powder to obtain a powder compacting green body. In a metal powder injection molding (MIM) method, a pellet is produced by adding a binder to a metal powder, and the pellet is injected into a mold to form a green body. In a casting method, a slurry is formed by adding a binder to a metal powder, the slurry is poured into a mold, released from the mold, and dried to produce a green body.

As a producing method of the precursor, among these methods, the additive manufacturing method is preferably used. In other words, the precursor is preferably a fabricated object fabricated by the additive manufacturing method. The method of manufacturing a bonded body according to the first embodiment may include a precursor producing step of producing a precursor. For example, the precursor producing step is performed before the sintering step S1 illustrated in FIG. 1.

Examples of the additive manufacturing method include a fused deposition modeling (FDM) method and a binder jetting (BJT) method.

The FDM method is a method of fabricating a green body by extruding a rod blending resin and metal through a narrow nozzle to laminate the extruded rod.

The BJT method is a fabricating method of a green body by adding a binder as a fabricating liquid to a powder layer including powder, solidifying the powder with the binder, and laminating the powder layer. In the BJT method, the solvent component of the binder contained in the obtained green body is dried to degrease.

As the additive manufacturing method, the BJT method is preferably used because a green body having a complicated shape that cannot be formed by a mold can be obtained.

The heating temperature in the sintering step (referred to as "sintering temperature" below) is not particularly limited. The sintering temperature is, for example, 300°C or more and 2500°C or less, preferably 400°C or more and 2000°C or less, and more preferably 500°C or more and 1000°C or less. When the sintering temperature is set to 300°C or more and 2500°C or less, a sintered body in which the precursor is sufficiently sintered can be obtained.

The heating time in the sintering step (referred to as sintering time below) is not particularly limited. For example, the sintering time is 15 minutes or more and 24 hours or less, preferably 30 minutes or more and 18 hours or less, and more preferably 1 hour or more and 12 hours or less. When the sintering time is set to 15 minutes or more and 24 hours or less, a sintered body in which the precursor is sufficiently sintered can be obtained.

In the sintering step, a sintered body having a specific sintered structure is produced. The sintered body includes a eutectic portion containing two or more elements and a crystal grain containing one metal element. The eutectic portion is a region in which solid phases of two compositions are crystallized. The crystal grain is surrounded by the eutectic portion. The expression "surrounded by the eutectic portion" indicates that the eutectic portion exists around the crystal grain, and it may not surround the entire periphery of the crystal grain with the eutectic portion. The eutectic portion is preferably unevenly distributed in the sintered body.

The average diameter of the crystal grain of the sintered body is 10 µm or more, preferably 50 µm or more, and more preferably 90 µm or more. The average diameter of the crystal grain is 500 µm or less, preferably 400 µm or less, and more preferably 200 µm or less.

In terms of the fabricating system of producing a precursor and sintering the precursor to obtain a sintered body, for example, a case where the BJT method is applied will be described with reference to FIG. 2. FIG. 2 is a schematic diagram of a fabricating system that produces a sintered body used in a method of manufacturing a bonded body according to an embodiment of the present disclosure. The fabricating system 1 includes a fabricating apparatus 100, a drying apparatus 200, an excessive powder removing apparatus 300, and a sintering apparatus 400.

The fabricating apparatus 100 fabricates a fabricated object. The drying apparatus 200 dries the fabricated object fabricated by the fabricating apparatus 100. The excess powder removing apparatus 300 removes excess powder attached to the fabricated object dried by the drying apparatus 200. The sintering apparatus 400 sinters the fabricated object from which the excess powder has been removed. In the sintering apparatus 400, the fabricated object may be degreased before sintering. In the sintering apparatus 400, the sintering step of the method of manufacturing a bonded body according to the present embodiment is performed.

The fabricating system 1 may be configured by four separate apparatuses of the fabricating apparatus 100, the drying apparatus 200, the excess powder removing apparatus 300, and the sintering apparatus 400, may be configured by integrating the four apparatuses into one apparatus, or may be configured by mounting a part of the functions to the fabricating apparatus 100 or the sintering apparatus 400. Further, at least some of the functions of the drying apparatus 200 or the excess powder removing apparatus 300 may be omitted as appropriate.

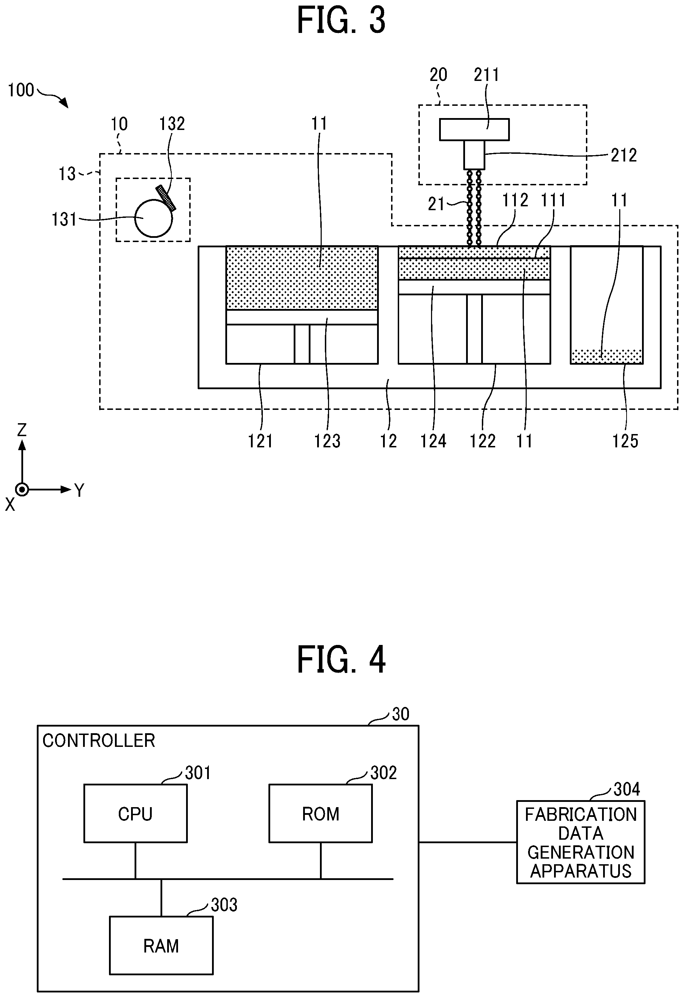

The fabricating apparatus 100 will be described below. FIG. 3 is a schematic diagram of a fabricating apparatus that produces a precursor used in a method of manufacturing a bonded body according to an embodiment of the present disclosure. FIG. 4 is a schematic diagram of a fabricating apparatus that produces a precursor used in a method of manufacturing a bonded body according to an embodiment of the present disclosure.

The fabricating apparatus 100 includes a fabricating unit 10 and an addition unit 20. The fabricating unit 10 fabricates a powder layer 111 including powder 11. The powder 11 is an example of a powder containing two or more elements contained in the precursor according to an embodiment of the present disclosure. The addition unit 20 adds a fabricating liquid 21 to the powder layer 111 to form a fabricating layer 112. In the fabricating apparatus 100, multiple fabricating layers 112 are laminated to fabricate a fabricated object.

The addition unit 20 adds a fabricating liquid 21 to the powder layer 111 to form a fabricating layer 112. In the fabricating apparatus 100, multiple fabricating layers 112 are laminated to fabricate a fabricated object.

The fabricating unit 10 includes a powder chamber 12 and a laminating unit 13. The powder chamber 12 includes a supply chamber 121, a fabricating chamber 122, a supply stage 123, a fabricating stage 124, and an excess powder chamber 125. The powder chamber 12 has a box shape. The three upper surfaces of the supply chamber 121, the fabricating chamber 122, and the excess powder chamber 125 are open. The laminating unit 13 includes a flattening member 131 and a powder removing member 132.

The supply chamber 121 is a chamber that supplies the powder 11 to the fabricating chamber 122. The supply chamber 121 accommodates the powder 11 to be supplied to the fabricating chamber 122. A supply stage 123 is disposed at the bottom of the supply chamber 121. The supply stage 123 moves up and down in the vertical direction (i.e., Z-direction). The side face of the supply stage 123 is disposed so as to be in contact with the inner face of the supply chamber 121.

The powder 11 required for fabrication is supplied from the supply chamber 121 to the fabricating chamber 122. In the fabricating chamber 122, a powder layer 111 and a fabricating layer 112 are formed. Further, in the fabricating chamber 122, multiple fabricating layers 112 are laminated and a fabricated object is fabricated.

The supply stage 123 is disposed at the bottom of the supply chamber 121. The fabricating stage 124 is disposed at the bottom of the fabricating chamber 122. The supply stage 123 and the fabricating stage 124 move up and down in the vertical direction (i.e., Z-direction). The side face of the fabricating stage 124 is disposed so as to be in contact with the inner face of the fabricating chamber 122. The top surfaces of the supply stage 123 and the fabricating stage 124 are maintained to be horizontal.

The excess powder chamber 125 is a chamber for accommodating the powder 11 that is an excess of the powder 11 flattened by the flattening member 131 when the powder layer 111 is formed. A unit or device that sucks the powder 11 may be disposed at the bottom of the excess powder chamber 125, or the excess powder chamber 125 may be removable. The excess powder chamber 125 is disposed adjacent to the fabricating chamber 122. The excess of the powder 11 accommodated in the excess powder chamber 125 may be returned to the supply chamber 121 or may be returned to the supply chamber 121 via a powder supply device.

The powder supply device may be disposed above the supply chamber 121, and supplies the powder 11 to the supply chamber 121 before the fabrication starts or when the amount of the powder 11 in the supply chamber 121 decreases. Although the powder chamber 12 includes two chambers, i.e., the supply chamber 121 and the fabricating chamber 122, the powder chamber 12 may include the fabricating chamber 122 alone, and the powder may be supplied from the powder supply device to the fabricating chamber 122.

As a method that transfers the powder 11 from the powder supply device to the supply chamber 121, a screw conveyor system using a screw or an air transport system using air can be used.

The flattening member 131 flattens the fabricating layer 112 or the powder layer 111. The flattening member 131 flattens the fabricating layer 112 by rotating a recoater as a rotator. The flattening member 131 is rotated to supply the powder 11 in the supply stage 123 of the supply chamber 121 to the fabricating chamber 122. Accordingly, the powder layer 111 is formed.

The flattening member 131 reciprocally moves in the Y-direction along the stage face (the face on which the powder 11 is stacked) of the fabricating stage 124. More specifically, the flattening member 131 horizontally moves from the outside of the supply chamber 121 so as to pass over the supply chamber 121 and the fabricating chamber 122.

Accordingly, the powder 11 is transferred to the fabricating chamber 122 to be supplied onto the fabricating chamber 122, and the flattening member 131 flattens the powder 11 while passing over the fabricating chamber 122. As a result, the powder layer 111 is formed. The flattening member 131 is a member longer than the inner dimensions of the forming chamber 122 and the supply chamber 121. A plate-shaped blade or a bar may be used as the flattening member 131.

The powder removing member 132 removes the powder attached to the flattening member 131. The powder removing member 132 moves together with the flattening member 131 in a state where the powder removing member 132 is in contact with the surrounding face of the flattening member 131.

The addition unit 20 includes a carriage 211 and a head 212. The head 212 adds the fabricating liquid 21 to the powder layer 111.

The head 212 is, for example, an inkjet head, and includes a nozzle row in which multiple nozzles are arranged. A colored fabricated object may be formed by applying a cyan fabricating liquid, a magenta fabricating liquid, a yellow fabricating liquid, or a single color of the fabricating liquid may be applied from multiple nozzles. The fabricating liquid may be applied by an ink jet method or a dispenser method.

At least one head 212 is mounted on the carriage 211, and reciprocally moves in the X-direction (main scanning direction), the Y-direction (sub-scanning direction), and the Z-direction by a motor and a guide member.

The fabricating apparatus 100 includes a controller 30. As illustrated in FIG. 4, the controller 30 includes a central processing unit (CPU) 301, a read-only memory (ROM) 302 that stores a program for executing control and other fixed data, and a random-access memory (RAM) 303 that temporarily stores fabrication data.

The fabrication data is received from a fabrication data generation apparatus 304 such as an external computer. The fabrication data generation apparatus 304 generates fabrication data by slicing a fabricated object of the final form into each fabricating layer 112. The controller 30 performs the operation of fabricating each fabricating layer 112. The fabrication data generation apparatus 304 may be separate from the fabricating apparatus 100 or may be integrated with the fabricating apparatus 100 as one body. The controller 30 may be disposed inside the fabricating apparatus 100 or outside the fabricating apparatus 100.

As a method of producing a precursor and a sintered body, for example, the case where the BJT method is applied is described above. Referring back to FIG. 1, a method of manufacturing a bonded body according to a first embodiment will be described.

In the bonding step, the sintered body and the object are bonded. The phrase "the sintered body and the object are bonded" indicates that two bonded members are bonded such that one of the bonded members is a sintered body and the other of the bonded members is an object. In the present specification, a bonded member refers to a member to be bonded, and the sintered body and the object correspond to the bonded members. The bonding step is performed in a bonding step S2 illustrated in FIG. 1.

The object is a bonded member separated from the sintered body constituting the other bonded member, but may be a sintered body obtained in the same manner as the sintered body constituting the other bonded body. The object may be, for example, a rolled body, a cast body, a forged body, or an extruded body. The rolled product does not include a sintered product, and is obtained by rolling a cast body obtained by melting powder.

In the bonding step, the sintered body is preferably heated in a temperature range in which a liquid phase is generated in the sintered body. It is more preferable that this temperature range is a temperature range in which the metal crystal (referred to as a metal crystal portion) generated in the sintered body does not generate a liquid phase. When the temperature at the time of bonding (which may be referred to as a bonding temperature or a bonding process temperature in the following description) is excessively high, the metal crystal may become a liquid phase and may lead to deformation of the member. When the bonding temperature is excessively low, the liquid phase of the eutectic portion may not be sufficiently developed and the bonding may be defective.

When the vicinity of the bonded surface of the sintered body bonded to the object is heated, a liquid phase is generated from the sintered body. In the present embodiment, the region generated by crystallization of two types of solid phases after the liquid phase in the sintered body produced by sintering is generated in the sintering step corresponds to the eutectic portion.

The temperature range in which the liquid phase is generated in the sintered body varies depending on the metal element contained in the sintered body. For example, in the case of a sintered body containing an aluminum alloy, the temperature range in which a liquid phase is generated in the sintered body is 300°C or more and 2500°C or less, preferably 400°C or more and 2000°C or less, more preferably 500°C or more and 1000°C or less, and still more preferably 550°C or more and 700°C or less.

In the bonding step, it is preferable to heat the sintered body containing the alloy in a temperature range in which a liquid phase of 5 mass% or more and less than 50 mass% is generated. In particular, in the case of a sintered body containing an aluminum alloy, heating is preferably performed in a temperature range in which a liquid phase of 5 mass% or more and 35 mass% or less is produced in the sintered body containing the aluminum alloy, more preferably in a temperature range in which a liquid phase of 10 mass% or more and 30 mass% or less is produced, and still more preferably in a temperature range in which a liquid phase of 15 mass% or more and to 25 mass% or less is produced.

When the liquid phase developed in the sintered body containing the aluminum alloy is less than 5 mass%, the liquid phase is insufficient to develop and the bonding does not proceed, which may lead to defective bonding. When the liquid phase developed in the sintered body containing the aluminum alloy exceeds 35 mass%, the liquid phase excessively is developed, which may be difficult to maintain the shape of the sintered body.

When the sintered body contains an aluminum alloy, the crystal grain included in the bonded body is made of aluminum, and the eutectic portion is made of an element constituting the aluminum alloy. The composition of the metal of the crystal grain is different form the composition of the eutectic portion. For example, when a sintered body that includes an alloy containing silicon element and aluminum element is used, the crystal grain included in the bonded body contains aluminum element, and the eutectic portion contains aluminum element and silicon element.

In the bonding step, the time required for bonding (referred to as bonding time) is any length of time, but is preferably set to a time so that the time during which a liquid phase is generated from the eutectic portion becomes 5 minutes or more. When the liquid phase is generated from the eutectic portion is 5 minutes or more in the bonding time, the liquid phase can be sufficiently filled in the boundary surface.

In the bonding step, the bonding environment is any environment. In the bonding step, for example, it is preferable that the bonding is performed in vacuum, a rare gas atmosphere such as nitrogen or argon, or a reducing atmosphere such as hydrogen. In the bonding step, when the sintered body and the object are bonded and fully cooled, the method of manufacturing a bonded body according to the first embodiment of the present disclosure is finished.

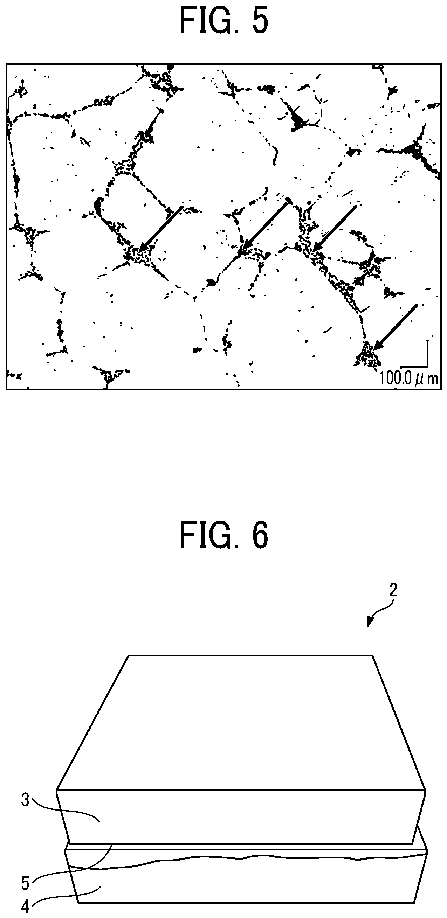

FIG. 5 is a schematic diagram of a cross-sectional optical microscopic photograph of a sintered body used in the method of manufacturing a bonded body according to the first embodiment of the present disclosure. As a cross section of the sintered body in the first embodiment, a bonded portion between the sintered body and an object includes a eutectic portion. The sintered body containing an alloy is generated by the sintering step while eutectic portions are unevenly distributed at boundary portions of the metal crystal. In FIG. 5, some of the eutectic portions are indicated by arrows.

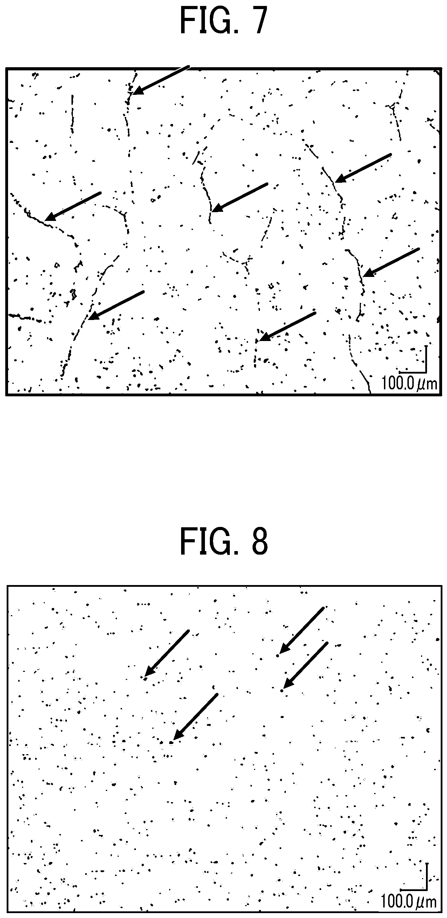

FIG. 6 is a diagram illustrating a bonded body according to an embodiment of the present disclosure. FIG. 7 is a schematic diagram of a cross-sectional optical microscopic photograph around a bonded boundary of a bonded body (in the case where an object bonded to the sintered body is a metal or an alloy) according to an embodiment of the present disclosure. In FIG. 7, some eutectic portions are indicated by arrows as in FIG. 5. FIG. 8 is a schematic diagram of a cross-sectional optical microscopic photograph of an object (in the case of a metal or an alloy) according to an embodiment of the present disclosure.

The bonded body 2 illustrated in FIG. 6 includes a sintered body 3 and an object 4. The sintered body 3 is disposed over the object 4 in the bonding step. The sintered body 3 and the object 4 are bonded to each other via a bonded portion 5.

The sintered body 3 is sintered by sintering a precursor containing two or more elements. The precursor is an object produced by a manufacturing method such as the BJT method or the MIM method.

The object 4 may be the same as or different from the sintered body 3. When the sintered body 3 is the same as the object 4, for example, the sintered body 3 and the object 4 may be produced by the BJT method, the sintered body 3 may be produced by the BJT method and the object 4 may be produced by the MIM method, or the sintered body 3 may be produced by the MIM method and the object 4 may be produced by the BJT method. When the sintered body 3 is different from the object 4, for example, the sintered body 3 is produced by the BJT method, and the object 4 is a rolled body or a cast body containing a metal or an alloy, or a molded body of ceramics.

The object 4 may have the same shape as the sintered body 3 or a different shape from the sintered body 3. Further, the object 4 may have the same size as the sintered body 3 or may have a different size from the sintered body 3.

When the object 4 contains a metal or an alloy and the sintered body 3 is reheated in the bonding step, in the bonded body 2 in which the sintered body 3 and the object 4 are bonded, eutectic portions of the sintered body 3 locally and preferentially become a liquid phase. The eutectic portions diffuse to the object 4 physically in contact with the sintered body 3 so that the bonding is progressed. As a cross section of the sintered body according to the present embodiment, the bonded portion between the sintered body and the object contains eutectic portions.

In FIG. 7, a cross section of the bonded body around the bonded boundary is illustrated such that the upper portion of the drawing is a sintered body and the lower portion of the drawing is an object containing a metal or an alloy. In FIG. 7, since there are the eutectic portions indicated by the arrows in the lower part of the drawing, it is found that the eutectic portions are diffused from the sintered body 3 toward the object 4.

At this time, since the metal crystal portion maintains a solid phase in the sintered body, the entire sintered body does not have deformation. As a result, the bonding can be performed while the sintered body maintains its shape. As illustrated in FIG. 8, eutectic portions are finely distributed in the entire rolled body. Thus, when the rolled bodies are bonded to each other in the present embodiment, the metal crystal portion cannot maintain the solid phase in the rolled body, and the entire rolled body may be deformed.

By contrast, since the method of manufacturing a bonded body according to the first embodiment includes the above-described sintering step and bonding step, a bonded body that maintains the shape of a bonded member can be provided without using a method of manufacturing a bonded body in the related art.

In a bonding method in the related art, flux is applied to break the oxide film on the metal surface and allow the liquid phase to permeate the interface.

By contrast, in the sintered body used in the present embodiment, when the eutectic portions unevenly distributed in the sintered body become a liquid phase, the oxide film existing on the metal surface and causing the sintering inhibition is destroyed. Thus, the flux is not applied. Accordingly, in the method of manufacturing a bonded body according to the first embodiment, a step for removing the flux after sintering can be omitted. In addition, since the flux is not used, a bonded body in which flux residue causing defective sintering is not generated can be provided.

Other examples of the bonding method in the related art used in the method of manufacturing the bonded body include brazing, friction stir welding, laser welding, and diffusion bonding.

Brazing is a method of heating a metal having a lower melting point than the bonded member and filling the gap of the bonded member with the metal.

Friction stir welding is a method of welding by frictional heat generated by overlaying bonded bodies and pressing a rotating tool against the boundary or its surroundings of the bonded bodies.

Laser welding is a method of bonding by overlaying bonded bodies and locally melting them by focusing the laser beam and irradiating the boundary or its surroundings with the laser beam. However, since the area in which the bonding can be performed is limited to an area with which the laser beam can be irradiated, the bonding is not suitable for a complicated shape. Further, since the bonding is performed at a point or a line with which the laser can be irradiated, it is not suitable for bonding on a wide area.

The diffusion bonding is a method of bonding by bringing base materials into close contact with each other, pressing the base materials at a temperature equal to or lower than the melting point of the base materials to such an extent that plastic deformation does not occur, and utilizing the diffusion of atoms generated between the bonded surfaces.

However, in the bonded bodies obtained by these methods in the related art, the quality of the bonding was poor.

By contrast, since the method of manufacturing a bonded body according to the first embodiment includes the above-described sintering step and bonding step, a bonding method having a good bonding quality can be provided.

Further, in the method of manufacturing a bonded body according to the first embodiment, since the bonded body is heated in a temperature range in which a liquid phase is generated in the sintered body in the bonding step, the bonding temperature is not excessively high. As a result, the deformation of the bonded body due to the development of the liquid phase in the metal crystal can be prevented. Further, since the sintered body is heated in such a temperature range, the bonding temperature is not excessively low. As a result, the liquid phase of the eutectic portion is sufficiently developed, and the bonding failure can be prevented.

Accordingly, in the method of manufacturing a bonded body according to the first embodiment, even when the sintered body and the object are bonded, the sintered body and the object can be bonded by bringing them into direct contact with each other without using a brazing material. As a result, according to the present embodiment, a method of manufacturing a bonded body having good bonding quality can be obtained.

In the method of manufacturing a bonded body according to the first embodiment, since the precursor is a fabricated object fabricated by the additive manufacturing method, a sintered body and a bonded body having a complicated shape that cannot be achieved by molding can be produced.

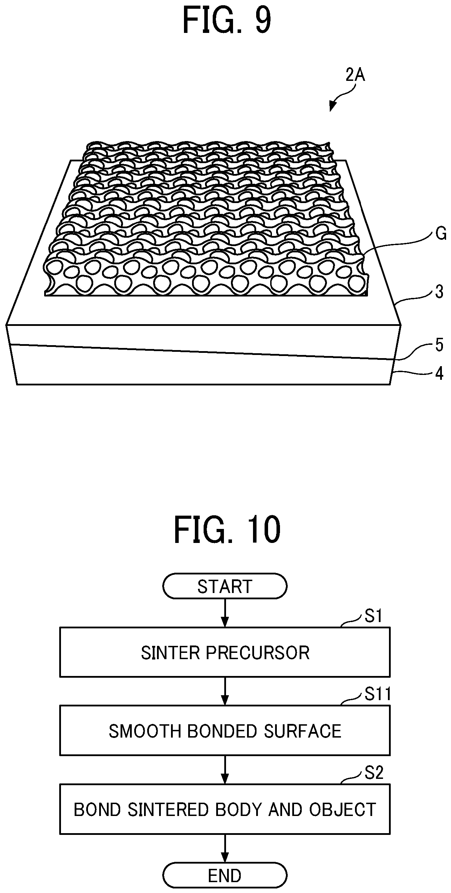

FIG. 9 is a diagram illustrating another bonded body according to an embodiment of the present disclosure. In FIG. 9, the same or like reference numerals as those in FIG. 6 are assigned to the same or corresponding parts as those in FIG. 6, and the description thereof is omitted.

The bonded body 2A illustrated in FIG. 9 includes a sintered body 3, and an object 4, and a bonded portion 5. The sintered body 3 has a gyroid structure G. In other words, the sintered body 3 including the gyroid structure G is bonded over the object 4.

Since the additive manufacturing method is the BJT method, a sintered body and a bonded body having a complicated shape that cannot be achieved by molding can be surely fabricated. Thus, according to the present embodiment, a bonded body 2A in which the sintered body 3 having a gyroid structure G is bonded to the object 4 can be provided.

In the manufacturing method according to the first embodiment, since the aluminum (Al) alloy is contained in the sintered body, the temperature at which the liquid phase of the alloy is generated is low. As a result, the influence of the sintered body on the structure of the object to be bonded can be reduced.

In the method of manufacturing a bonded body according to the first embodiment, since the sintered body is heated in the bonding step in a temperature range in which a liquid phase of 5 mass% or more and 50 mass% or less is generated in the sintered body, a sufficient liquid phase is generated from the eutectic portion, and bonding failure can be prevented. In addition, since the excessive liquid phase development is prevented, the shape of the sintered body or the bonded body can be maintained. The liquid phase generation rate can be calculated by thermodynamic calculation based on the alloy composition.

### Second Embodiment

FIG. 10 is a flowchart of a method of manufacturing a bonded body according to a second embodiment of the present disclosure. In FIG. 10, the same or like reference signs as those in FIG. 1 are assigned to the same or corresponding parts as those in the first embodiment, and the description thereof is omitted.

The method of manufacturing a bonded body according to the second embodiment further includes a smoothing step. The smoothing step is performed before the bonding step. In the smoothing step, the bonded surface of at least one of the sintered body or the object is smoothed. The bonded surface is a surface of each of a bonded member and another bonded member that contact each other. The smoothing step is performed in a smoothing step S11 illustrated in FIG. 10.

The process method in the smoothing step is not limited to any particular method. Examples of the process method of the smoothing step include a cutting process using a tool such as a milling cutter, a grinding process using a tool such as a grinding stone, or a polishing process such as buffing or electrolytic polishing. Since the bonded surface is smoothed in this way, the surface roughness of the surface that has been processed before and after the smoothing process can be reduced.

The surface roughness Ra of the bonded surface after smoothing is any value, but is preferably 12.5 µm or less, more preferably 8.4 µm or less, and still more preferably 6.3 µm or less. When the surface roughness Ra of the bonded surface is 12.5 µm or less, a gap generated between a bonded surface of a bonded member and a bonded surface of another bonded member can be reduced at the time of bonding.

The surface roughness Ra can be measured using a laser microscope (e.g., 3D Laser Scanning Confocal Microscope VK-X1000 manufactured by KEYENCE Corporation). In the case of using a laser microscope, as measurement conditions, 14 measurement lines (7 horizontal lines at a line spacing of 0.40 millimeters (mm), 7 vertical lines at a line spacing of 0.27 mm) are drawn in a range of 2.74 × 2.06 mm at a measurement pitch of 12 µm in the Z-direction at with a lens magnification of 5 times, and the average value of the roughness is defined as the surface roughness Ra.

Since the method of manufacturing a bonded body according to the second embodiment includes the smoothing step, a more preferable bonding quality can be provided.

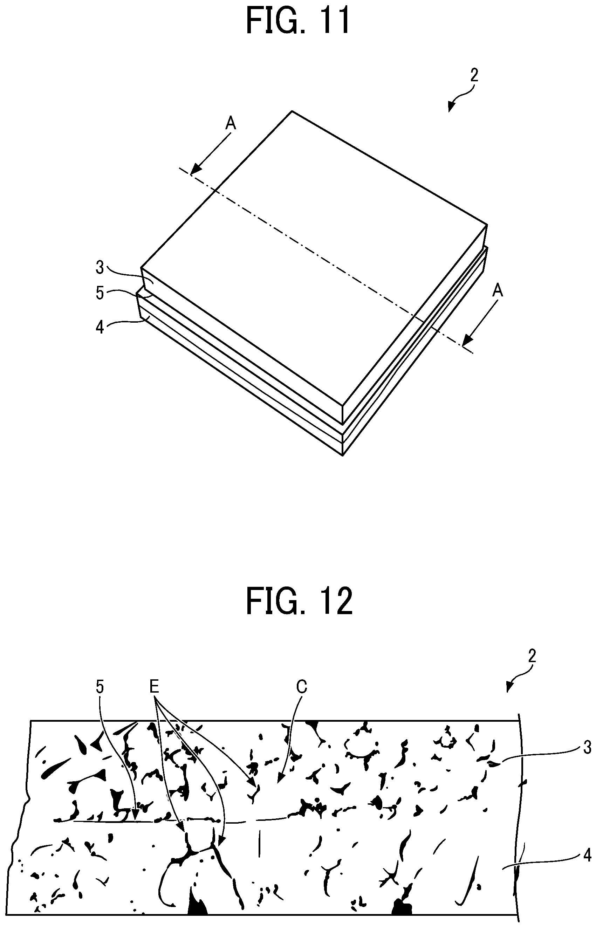

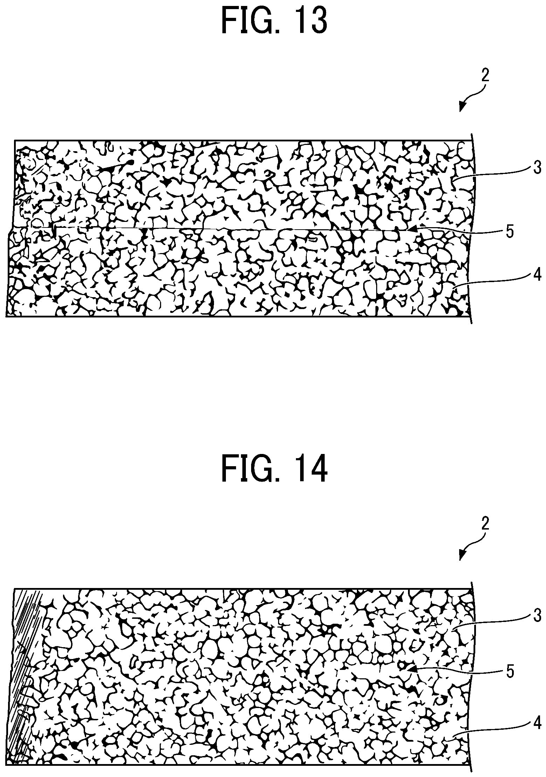

FIG. 11 is a diagram illustrating a bonded body according to an embodiment of the present disclosure. FIG. 12 is a schematic diagram of a cross-sectional optical microscopic photograph around a bonded boundary of a bonded body bonding a sintered body and an object, according to an embodiment of the present disclosure. FIG. 13 is a schematic diagram of a cross-sectional optical microscopic photograph around a bonded boundary of a bonded body bonding sintered bodies, according to an embodiment of the present disclosure. FIG. 14 is a schematic diagram of a cross-sectional optical microscopic photograph around a bonded boundary of a bonded body bonding sintered bodies, according to the second embodiment of the present disclosure. In FIGS. 12 and 13, the same or like reference signs as those in FIG. 11 are assigned to the same or corresponding parts as those in FIG. 11, and the description thereof is omitted.

The view of the A-A cross section of the bonded body 2 illustrated in FIG. 11 is illustrated in FIGS. 12 to 14 In FIGS. 12 and 13, the smoothing step was not performed, and in FIG. 14, the smoothing step was performed.

For example, as illustrated in FIG. 12, in the bonded body 2 in which the sintered body 3 and the object 4 are bonded, the bonded portion 5 that is the boundary between the sintered body 3 and the object 4 can be visually recognized. In FIG. 12, the crystal grain C in the white portion and the eutectic E in the black portion can be visually recognized. Further, in the bonded body 2, the eutectic E is visually recognized in the sintered body 3 and even in the object 4. The eutectic E dissolved from the sintered body 3 penetrates into the object 4, and the sintered body 3 and the object 4 are bonded.

Similarly, in FIG. 13, when the sintered bodies are bonded to each other, the boundary of the bonded portion 5 can be visually recognized. By contrast, when the sintered bodies illustrated in FIG. 14 are bonded to each other after being smoothed, the boundary of the bonded portion 5 is hardly visible.

In addition, since the smoothing step is performed in this manner, the bonded portion 5 of the obtained bonded body can be brought into close contact with each other. As a result, the bonding strength of the bonded portion 5 of the bonded body is further increased.

### Third Embodiment

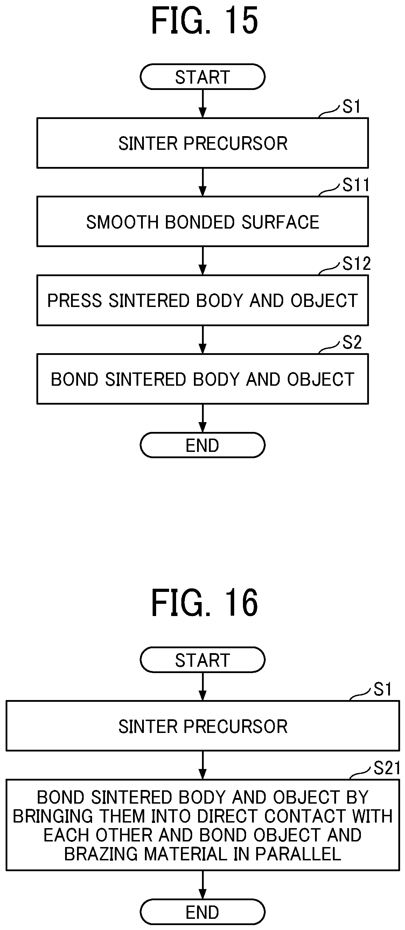

FIG. 15 is a flowchart of a method of manufacturing a bonded body according to a third embodiment of the present disclosure. In the third embodiment according to the present disclosure, the same or like reference signs as those in FIGS. 1 and 10 are assigned to the same or corresponding parts as the first and second embodiments described above, and redundant description is appropriately simplified or omitted.

The method of manufacturing a bonded body according to the third embodiment further includes a pressing step. The pressing step may be performed before or during the bonding step, but is preferably performed during the bonding step. In the pressing step, pressure is applied in a direction in which the sintered body and the object are bonded (i.e., bonded direction). The direction in which the sintered body and the object are bonded is the direction in which the bonded surface of the sintered body and the bonded surface of the object face each other at the time of bonding. The pressing step is performed in a pressing step S12 illustrated in FIG. 15.

The pressing method performed in the pressing step is any method. As a pressing method, for example, there is a method of applying a surface pressure by placing a weight on two bonded members that are overlaid at the time of bonding.

The pressure at the time of pressing is any pressure. When the pressure applied during the pressing is excessively high, the bonded member may be deformed depending on the shape of the bonded member.

In the method of manufacturing a bonded body according to the third embodiment, since the pressing step is included, the bonded members are brought into close contact with each other at the time of bonding, the wet of the liquid phase more spreads, and the voids at the boundary interface of the bonded portion of the bonded body are reduced. As a result, the bonding quality is increased.

### Fourth Embodiment

FIG. 16 is a flowchart of a method of manufacturing a bonded body according to a fourth embodiment of the present disclosure. In the fourth embodiment, the same or like reference signs as those in FIGS. 1, 10, and 15 are assigned to the same or corresponding parts as the first, second, and third embodiments described above, and redundant description is appropriately simplified or omitted.

The bonded body of the fourth embodiment includes a sintered body, an object, and a brazing member. In the method of manufacturing a bonded body according to the fourth embodiment, in the bonding step, bonding by brazing is also performed between the surfaces of the object and the brazing member that are brought into contact with each other. Specifically, as illustrated in FIG. 16, in the bonding step S21, when the sintered body is heated in a temperature range in which a liquid phase is generated in the sintered body, the sintered body and the object are brought into direct contact with each other and bonded together, and at the same time, the object and the brazing member are bonded together.

In the fourth embodiment, the object and the brazing member are bonded by the heating process in the bonding step in a region different from the bonding region in which the sintered body and the object are bonded. In the fourth embodiment, the region of the object in which the object and the brazing member are bonded is a region different from the bonding region in which the sintered body and the object are bonded. In other words, the object and the brazing member are brought into contact with each other in a region different form the region in which the object and the brazing member are brought into direct contact with each other to be bonded.

The brazing member may be coated with a brazing material, or the brazing member to which a brazing material is applied may be used. The brazing material is appropriately selected depending on the object and the brazing member to be bonded by brazing. Examples of the brazing material for aluminum include Toyal Hyper Braze (registered trademark) manufactured by Toyo Aluminum K.K. and XuperBraze 190 PA manufactured by Castolin Eutectic Co., Ltd.. The brazing material may contain a flux. When a brazing material containing a flux is used, the flux may not be applied to the brazed member.

The method of manufacturing a bonded body according to the fourth embodiment uses an object cut to the dimensions of a sintered body. The sintering step S1 may be followed by a dimension measuring step and a cutting step. In the dimension measuring step, the size of the sintered body is measured. As a measuring tool or device for measuring the dimensions of the sintered body, for example, a caliper, a non-contact 3D measuring device (e.g., 3D Scanner VL 500 manufactured by KEYENCE Corporation) can be used. In the cutting step, the object is cut in accordance with the dimensions of the sintered body measured in the dimension measuring step.

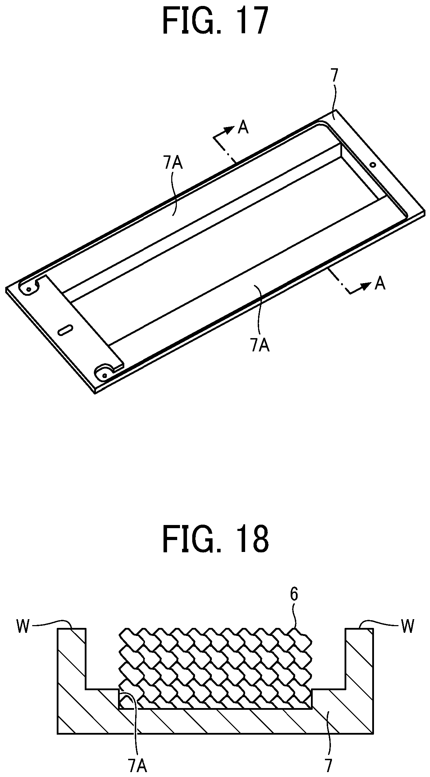

In the cutting step, as illustrated in FIGS. 17 to 19, steps 7A may be disposed in the container 7 made of metal, which is an example of the object, in accordance with the size of the sintered body 6 to be bonded. Since the step 7A is disposed, the sintered body 6 can be fixed to the step 7A of the container 7 made of metal.

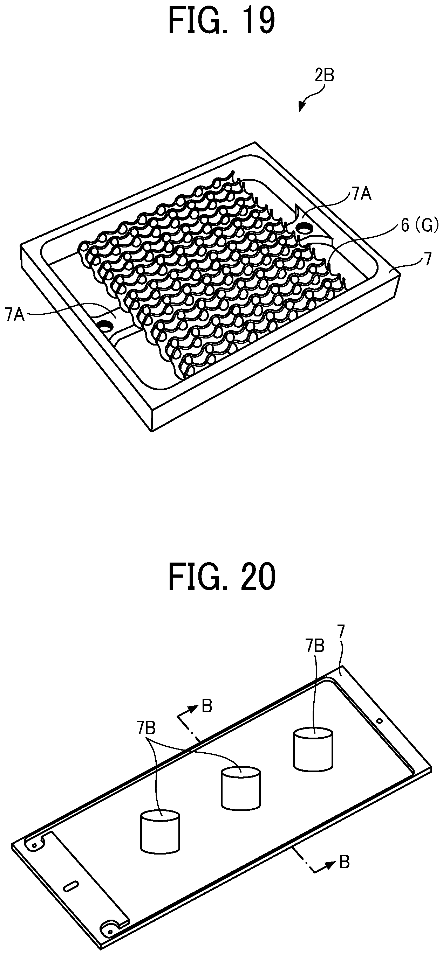

For example, as illustrated in FIGS. 17 and 18, the steps 7A may be entirely disposed at two opposed sides of the container 7 of a substantially rectangular parallelepiped, or as illustrated in FIG. 19, the steps 7A may be disposed at a part of the sides of the container 7. In FIGS. 17 and 19, a single step 7A is disposed at each of the two opposed sides. However, the number, location, and shape of the step 7A may be appropriately selected in accordance with the shape and size of the sintered body. FIG. 18 is a cross-sectional view of the container 7 taken along the line A-A in FIG. 17. The sintered body 6 is fixed by the steps 7A.

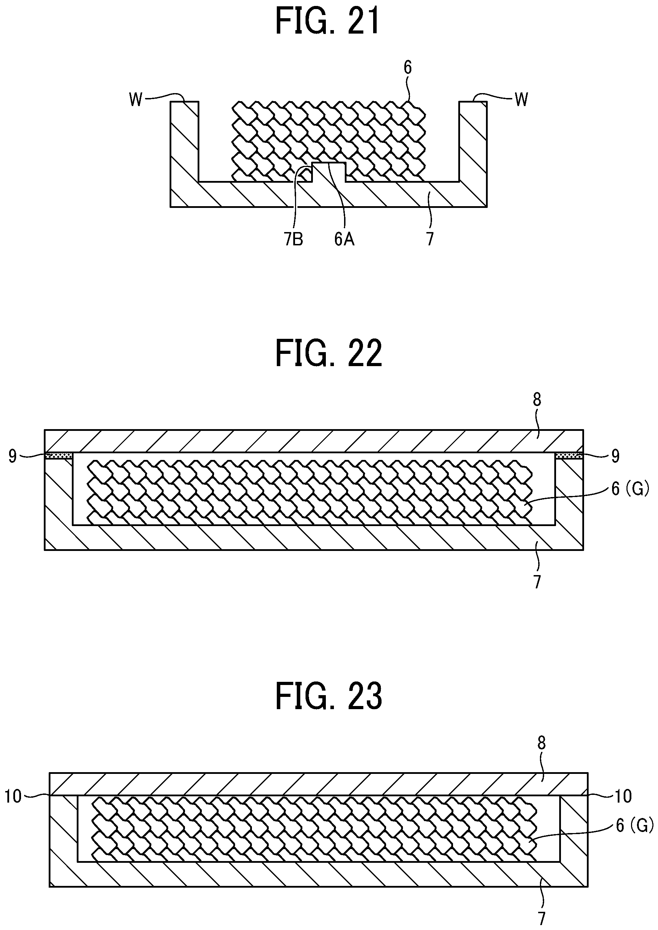

In the cutting step, as illustrated in FIGS. 20 and 21, multiple protrusions 7B are disposed at a container 7 of metal as an example of object so as to be aligned with the bonding position of the sintered body 6, and recesses 6A formed in the sintered body 6 in advance are fit to the multiple protrusions 7B of the container 7 made of metal. FIG. 21 is a cross-sectional view of the container 7 taken along the line B-B in FIG. 20. The sintered body 6 is fixed by the protrusions 7B.

The shape, number, and arrangement of the protrusion 7B are appropriately selected in accordance with the shape and size of the recess formed in the sintered body. Two or more recesses are formed in the sintered body 6, and the protrusions having the same number of the recesses are formed in the container 7. Accordingly, the bonding can be performed more accurately. Forming the step 7A and the protrusion 7B allows the sintered body 6 to be bonded to the aimed position of the container 7. As a result, the function as designed can be implemented for bonded component.

In the brazing step, as illustrated in FIG. 22, a cover 8, which is a brazing member, and a brazing material 9 are brought into contact with the upper surface of the container 7, and are placed in the furnace. Accordingly, as illustrated in FIG. 23, a bonded body in which the sintered body 6 is surrounded and encased by the container 7 and the cover 8 is obtained.

The bonded body encased illustrated in FIG. 23 can be used, for example, as a heat sink. A heat sink is a device that cools by dissipating (radiating) absorbed heat into the air. When the encased bonded body illustrated in FIG. 23 is used as a heat sink, a cooling liquid such as water may be injected into the heat sink and circulated.

In the bonding method according to the fourth embodiment, the object and the brazing member are bonded in parallel with the bonding of the sintered body and the object in direct contact with each other. As a result, the aimed bonded body can be manufactured in a single step. Accordingly, the bonding of the sintered body 6 and the container 7 and the brazing of the container 7 and the cover 8 can be performed by a single heating device without preparing two heating devices individually. In addition, since the heating process is performed only once, the process time is also minimized.

Since such an encased bonded body for the heat sink is used, the internal structure of the heat sink can be designed into a complicated structure, and thus the cooling efficiency by the heat sink can be increased.

### Fifth Embodiment

A method of manufacturing a bonded body according to a fifth embodiment of the present disclosure is performed in accordance with the flowchart illustrated in FIG. 16. The method of manufacturing a bonded body according to the fifth embodiment uses an object obtained by pressing a sheet metal, which is different from the manufacturing method according to the fourth embodiment In the fifth embodiment, the same or like reference signs as those in FIGS. 1, 10, 15, and 16 are assigned to the same or corresponding parts as those in the first, second, third, and fourth embodiments described above, and redundant description is appropriately simplified or omitted.

The bonded body of the fifth embodiment also includes a sintered body, an object, and a brazing member. In the method of manufacturing the bonded body according to the fifth embodiment, as in the fourth embodiment illustrated in FIG. 16, bonding is performed by brazing between the surfaces of the object and the brazed member in contact with each other in the bonding step. The region of the object in which the object and the brazing member are bonded is different from the bonding region in which the sintered body and the object are bonded. In other words, the object and the brazing member are brought into contact with each other in the region different form the bonding region in which the object and the brazing member are brought into direct contact with and bonded to each other.

In the fifth embodiment, as illustrated in FIG. 16, in the bonding step S21, the sintered body and the object are brought into direct contact with and bonded to each other, and at the same time, the object and the brazing member are bonded together at the time of heating the sintered body in a temperature range in which a liquid phase is generated in the sintered body. The object and the brazing member are in contact with each other via the brazing material. In the bonding step, the surfaces of the object and the brazing member that are brought into contact with each other are bonded by brazing.

In the fifth embodiment, the object and the brazing member are bonded by the heating process in the bonding step in a region different from the bonding region in which the sintered body and the object are bonded. In the method of manufacturing a bonded body according to the fifth embodiment, an object obtained by pressing a sheet metal is used. The manufacturing method may include a sheet metal forming step, a strain measuring step, and a precursor producing step before the sintering step S1.

In the sheet metal forming step, the sheet metal is pressed to produce an object. In the pressing step, an object including a step or a protrusion may be produced. In the pressing step, for example, bending is performed. In the strain measuring step, the dimensions of the object obtained by pressing step are measured. In the precursor producing step, a precursor is produced in accordance with the strain of the object measured in the strain measuring step.

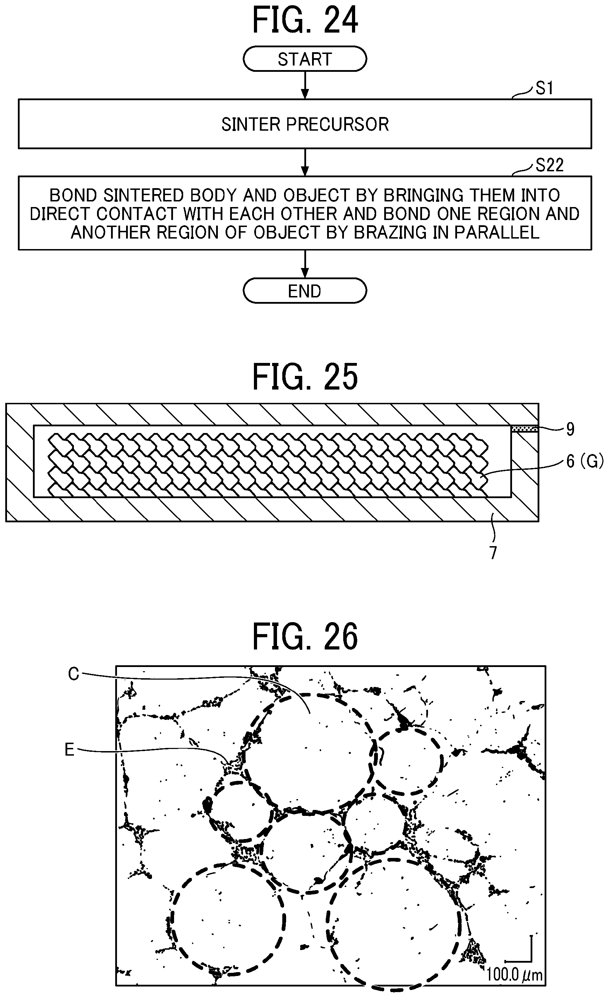

Since an object obtained by pressing a sheet metal is used, the cost can be reduced as compared with the case where the object is produced by cutting. The object and the brazing member used in the method of manufacturing the bonded body according to the fifth embodiment may be the same. FIG. 25 is a diagram illustrating a form in which the object and the brazing member are bonded as one body as a bonded body according to the fifth embodiment.

FIG. 24 is a flowchart of a method of manufacturing the bonded body illustrated in FIG. 25. In FIG. 25, one region of the object and another region of the object are bonded by brazing in a region different from the bonding region in which the sintered body and the object are bonded by heating process in the bonding step. In the fifth embodiment illustrated in FIG. 25, as illustrated in FIG. 24, in the bonding step, one region and another region of the object are bonded by brazing in parallel with the bonding of the sintered body and the object. The region bonded by brazing is different from the region in which the sintered body and the object are bonded. In the sheet metal forming step, since the container 7 and the cover 8 are integrally formed as one body, the object and the brazing member can be identical. In the bonded body illustrated in FIG. 25, the sintered body 6 is encased in a container 7 including the cover integrally formed as one body.

In the bonding method according to the fifth embodiment, the object and the brazing member are bonded in parallel with the bonding of the sintered body and the object in direct contact. As a result, the aimed bonded body can be formed in a short step. Accordingly, since multiple heat processes that are extremely costly can be performed with a single apparatus, an enormous increase in manufacturing cost can be prevented.

### Bonded Body

The bonded body according to an embodiment of the present disclosure is a bonded body in which a sintered body and an object are directly bonded. The bonded body of the present embodiment is obtained by the method of manufacturing the bonded body according to the present embodiment described above.

In the bonded body of the present embodiment, the sintered body contains an alloy. The element contained in the alloy is not particularly limited, but a metal element selected from, for example, aluminum (Al), iron (Fe), titanium (Ti), copper (Cu), silver (Ag), gold (Au), magnesium (Mg), calcium (Ca), or a zinc (Zn). Preferably, the alloy is an Al alloy. Preferably, the Al alloy is an AlSi alloy or an AlSiMg alloy.

FIG. 26 is an enlarged view of a sintered body according to an embodiment of the present disclosure. FIG. 26 corresponds to an enlarged view of a cross section of the sintered body 3 included in the bonded body 2 illustrated in FIG. 6. The sintered body included in the bonded body includes a crystal grain C surrounded by a eutectic E. The average diameter of the crystal grain C of the sintered body is 10 µm or more, preferably 50 µm or more, and more preferably 90 µm or more. The average diameter of the crystal grain C is 500 µm or less, preferably 400 µm or less, and more preferably 200 µm or less.

The average diameter of the crystal grain included in the bonded body is an average of the grain diameter of the crystal grain. The method of checking the grain diameter of the crystal grain is any method. For example, the cross section in the thickness direction may be observed by an optical microscope, a scanning electron microscope (SEM), or a transmission electron microscope (TEM), or analyzed by electron backscattered diffraction (EBSD).

When the average diameter of the crystal grain in the sintered body included in the bonded body is 90 µm or more and 500 µm or less, the sintered body can be bonded with good bonding quality. In addition, the deformation of the object at the time of bonding can be prevented.

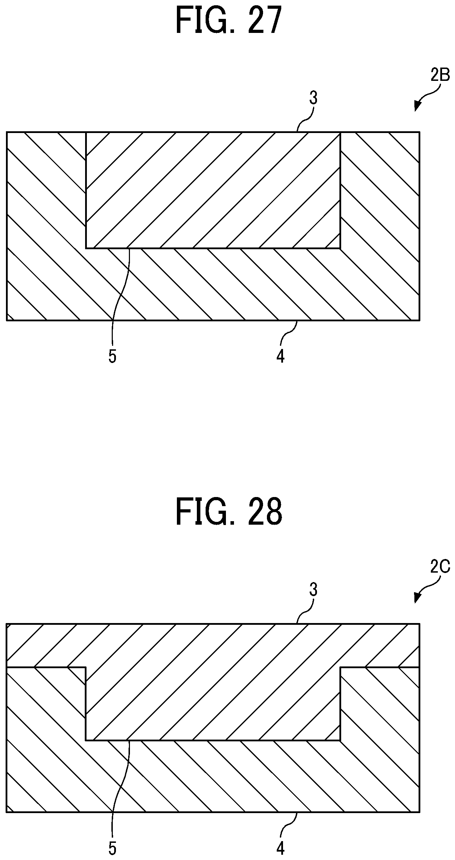

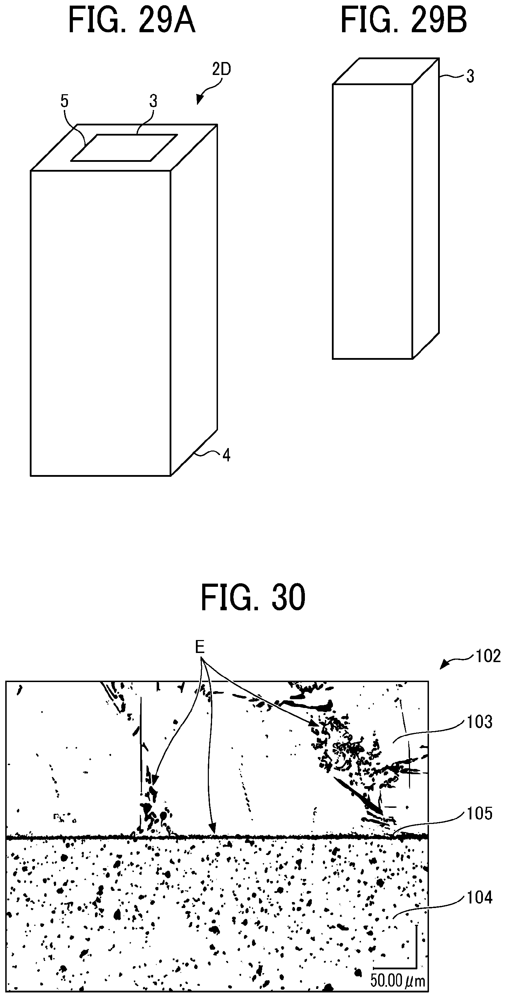

FIG. 27 is a diagram illustrating a bonded body according to a first modification of the present disclosure. FIG. 28 is a diagram illustrating a bonded body according to a second modification of the present disclosure. FIGS. 29A and 29B are diagrams illustrating a bonded body according to a third modification of the present disclosure. In FIGS. 27 to 29B, the same or like reference signs as those in FIG. 6 are assigned to the same or corresponding parts as those in FIG. 6, and the description thereof is omitted.

In each of the bonded body 2B illustrated in FIG. 27 and the bonded body 2C illustrated in FIG. 28, the sintered body 3 is inserted into the object 4 having a recess. Unlike the bonded body 2B illustrated in FIG. 27, the bonded body 2C illustrated in FIG. 28 is formed by bonding the sintered body 3 to the upper surface of the recess of the object 4. The bonded body 2D illustrated in FIG. 29A has a cavity in the object 4, and the sintered body 3 is inserted into the cavity.

As illustrated in FIGS. 27 to 29B, as in FIG. 12, the bonded body 2B, 2C, and 2D include the bonded portion 5 that is the boundary between the sintered body 3 and the object 4. The eutectic E dissolved from the sintered body 3 penetrates into the object 4, and the sintered body 3 and the object 4 are bonded

In the bonded body according to the present embodiment, since the sintered body contains two or more metal elements, and the sintered body includes a crystal portion and a crystal grain surrounded by a eutectic portion, the solid phase of the metal crystal portion is maintained during sintering. As a result, the entire sintered body is less likely to be deformed and the shape of the sintered body is maintained.

When the average diameter of the crystal grain is 10 µm or more, the entire sintered body is less likely to be deformed and the shape of the sintered body is maintained.

Further, since the crystal grain contains aluminum element and the eutectic portion contains aluminum element and silicon element, the entire sintered body is less likely to be deformed and the shape of the sintered body is maintained.

In addition, when the eutectic portions that are unevenly distributed in the sintered body become a liquid phase, the oxide film that exists on the metal surface and becomes a factor that inhibits sintering is destroyed. Accordingly, it is not necessary to apply a flux at the aim of removing the oxide film. Thus, the bonded body of the present embodiment does not contain impurities such as flux at the interface. In addition, the bonded body according to the present embodiment has high adhesion strength between the sintered body and the object because there is no flux between the sintered body and the object.

### Object

In the bonded body according to an embodiment of the present disclosure, the object indicates a structural body to be bonded to the sintered body. Since the object is bonded to the sintered body, a shape or strength suitable for the purpose of the bonded body can be added. The object preferably has a melting point equal to or higher than the sintered body. Since the object has the melting point equal to or higher than the sintered body, the deformation of the object at the time of bonding can be prevented.

The phrase "the melting point equal to or higher than the sintered body" indicates that the melting point of the object is equal to or higher than that of the alloy constituting the sintered body.

In the present specification, the melting point refers to the temperature at which the generation of the liquid phase begins, as measured by thermodynamic calculation. The thermodynamical calculation can be performed by using, for example, the thermodynamic equilibrium calculation software (The Chemical and Thermodynamic Equilibrium Calculator (CaTCalc) developed by Research Institute of Computational Thermodynamics Inc.).

Examples of the material constituting the object include metals and ceramics. Examples of the metal include aluminum (Al), iron (Fe), titanium (Ti), copper (Cu), silver (Ag), gold (Au), magnesium (Mg), calcium (Ca), or zinc (Zn). Examples of the ceramics include alumina (Al₂O₃), silicon nitride (Si₃N₄), zirconium oxide (ZrO₂), or aluminum nitride (AlN). When the sintered body contains an aluminum alloy, the object preferably contains an aluminum alloy. Since the object contains an aluminum alloy, the object can be bonded with a good bonding quality.

In the bonded body according to an embodiment of the present disclosure, the sintered body is encased in a case including at least an object. The case corresponds to, for example, the container 7 and the cover 8 that are members of the above-described encased bonded body illustrated in FIG. 23. The bonded body encasing the sintered body corresponds to the above-described encased bonded body illustrated in FIG. 23.

The bonded body of the present embodiment can be used as a heat sink by encasing the sintered body in a case including at least an object.

The heat sink including the bonded body according to the present embodiment can increase the cooling efficiency of the heat sink because the internal structure of the heat sink can be designed to be a complicated structure.

FIG. 30 is a schematic diagram of a cross-sectional optical microscopic photograph around a bonded boundary of another bonded body (in the case where the object to be bonded to the sintered body is ceramics) according to an embodiment of the present disclosure. In FIG. 30, the parts corresponding to those in FIG. 11 are denoted by reference numerals obtained by adding 100 to the reference numerals illustrated in FIG. 11, and the description thereof will be omitted. In FIG. 30, a cross section of the bonded body around the bonded boundary is illustrated such that the upper portion of the drawing is a sintered body and the lower portion of the drawing is an object of a ceramics plate.

As illustrated in FIG. 30, even in the bonding between the sintered body 103 and the object 104 (ceramics), eutectic portions become a liquid phase and diffuse to the ceramics. In other words, in the bonding of the ceramics and the sintered body, the sintered body becomes preferentially a liquid phase, and the bonding progresses while maintaining the shape of the bonded body, as in the bonding of the object containing the metal or the alloy and the sintered body.

When the object to be bonded to the sintered body contains a metal or an alloy, the eutectic E is also diffused into the object as described above. However, when the object to be bonded to the sintered body is a ceramics, the eutectic E does not diffuse into the ceramics, and only the liquid phase penetrates the unevenness of the surface of the ceramics at the boundary portion 105 between the sintered body 103 and the object 104.

As described above, in the still another bonded body according to an embodiment of the present disclosure, the shape of the sintered body 103 is maintained in the state where the sintered body 103 is fixed to the surface of the object 104 by the anchor effect. Thus, even when the sintered body and the ceramics are bonded, the entire sintered body is not deformed, and the bonding can be performed while maintaining the shape of the sintered body.

### Examples

The present disclosure will be described in more detail with reference to the following Examples, but the present disclosure is not limited to these Examples. In the following description, "%" is based on mass unless otherwise specified. The following methods are used for various tests and evaluations.

### Production of Bonded Body

Bonded bodies in which sintered bodies obtained by sintering precursors and rolled bodies were bonded (Examples 1 to 5 and 8 to 13), bonded bodies in which sintered bodies were bonded to each other (Examples 6 and 7), bonded bodes in which sintered bodies and ceramics were bonded (Examples 14 and 15), and bonded bodies in which rolled bodies were bonded to each other (Comparative Examples 1 to 4) were produced. The conditions and bonding quality of each bonded body are listed in Tables 1 and 2.

**Table 1**

| EXAMPLE | BONDED BODY (ALLOY COMPOSITION) | SINTERING TIME | AVERAGE DIAMEER OF CRYSTAL GLAIN | SMOOTHING PROCESS | BONDING PROCESS TEMPERATURE | LIQUID PHASE GENERATION RATIO AT BONDING | BONDING QUALITY |
|---|---|---|---|---|---|---|---|
| EXAMPLE 1 | BJT SINTERED BODY (AlSi ALLOY) - ROLLED BODY (AlSiMg ALLOY) | MIDDLE (4 hours) | 200 µm | YES | 575 - 610°C | MIDDLE (20%) | VERY GOOD |
| EXAMPLE 2 | BJT SINTERED BODY (AlSi ALLOY) - ROLLED BODY (AlSiMg ALLOY) | SHORT (2 hours) | 100 µm | YES | 575 - 610°C | MIDDLE (20%) | VERY GOOD |
| EXAMPLE 3 | BJT SINTERED BODY (AlSi ALLOY) - ROLLED BODY (AlSiMg ALLOY) | LONG ( 10 hours) | 400 µm | YES | 575 - 610°C | MIDDLE (20%) | VERY GOOD |
| EXAMPLE 4 | BJT SINTERED BODY (AlSi ALLOY) - ROLLED BODY (AiSiMg ALLOY) | MIDDLE (4 hours) | 200 µm | YES | 620 - 640°C | LARGE (50%) | GOOD |
| EXAMPLE 5 | BJT SINTERED BODY (AlSi ALLOY) - ROLLED BODY (COPPER C1100) | MIDDLE (4 hours) | 200 µm | YES | 575 - 610°C | MIDDLE (20%) | VERY GOOD |
| EXAMPLE 6 | BJT SINTERED BODY (AlSi ALLOY) -BJT SINTERED BODY (AlSiMg ALLOY) | MIDDLE (4 hours) | 200 µm | YES | 575 - 610°C | MIDDLE (20%) | VERY GOOD |
| EXAMPLE 7 | BJT SINTERED BODY (AlSi ALLOY) - BJT SINTERED BODY (AlSi ALLOY) | MIDDLE (4 hours) | 200 µm | NO | 575 - 610°C | MIDDLE (20%) | GOOD |
| EXAMPLE 8 | BJT SINTERED BODY (AlSiMg ALLOY) - ROLLED BODY(AlSiMg ALLOY) | MIDDLE (4 hours) | 200 µm | YES | 565 - 600°C | MIDDLE (20%) | VERY GOOD |
| EXAMPLE 9 | MIM SINTERED BODY (AlSiMg ALLOY) - ROLLED BODY (AlSiMg ALLOY) PLATE | MIDDLE (4 hours) | 200 µm | YES | 565 - 600°C | MIDDLE (20%) | VERY GOOD |
| EXAMPLE 10 | BJT SINTERED BODY (AlSi ALLOY) - PRESSED PRODUCT OF ROLLED BODY(AlMg ALLOY) PLATE | MIDDLE (4 hours) | 200 µm | YES | 575 - 610°C | MIDDLE (20%) | VERY GOOD |
| EXAMPLE 11 | BJT SINTERED BODY (AlSi ALLOY), CASE: ROLLED BODY (AlSiMg ALLOY), COVER: ROLLED BODY (PURE Al) AND BRAZING MATERIAL | MIDDLE (4 hours) | 200 µm | YES | 575 - 610°C | MIDDLE (20%) | VERY GOOD |
| EXAMPLE 12 | BJT SINTERED BODY (AlSi ALLOY), CASE: ROLLED BODY (PURE Al), COVER: BRAZING SHEET AND BRAZING MATERIAL LAYER CLADDED WITH AlSi ALLOY ON SURFACE OF AlMn ALLOY | MIDDLE (4 hours) | 200 µm | YES | 575 - 610°C | MIDDLE (20%) | VERY GOOD |
| EXAMPLE 13 | BJT SINTERED BODY (AlSi ALLOY), CASE: PRESSED PRODUCT OF ROLLED BODY (AlMn ALLOY) PLATE, COVER: BRAZING SHEET AND BRAZING MATERIAL LAYER CLADDED WITH AlSi ALLOY ON SURFACE OF AlMn ALLOY | MIDDLE (4 hours) | 200 µm | YES | 575 - 610°C | MIDDLE (20%) | VERY GOOD |
| EXAMPLE 14 | BJT SINTERED BODY (AlSi ALLOY) - ALUMINA PLATE (Al₂O₃) | MIDDLE (4 hours) | 200 µm | YES | 575 - 610°C | MIDDLE (20%) | VERY GOOD |
| EXAMPLE 15 | BJT SINTERED BODY (AlSi ALLOY) - SILICON NITRIDE PLATE (Si₃N₄) | MIDDLE (4 hours) | 200 µm | YES | 575 - 610°C | MIDDLE (20%) | VERY GOOD |

**Table 2**

| EXAMPLE | BONDED BODY (ALLOY COMPOSITION) | SINTERING TIME | AVERAGE DIAMEER OF CRYSTAL GLAIN | SMOOTHING PROCESS | BONDING PROCESS TEMPERATURE | LIQUID PHASE GENERATION RATIO AT BONDING | BONDING QUALITY |
|---|---|---|---|---|---|---|---|
| COMPARATIVE EXAMPLE 1 | ROLLED BODY (AlSiMg ALLOY) - ROLLED BODY (AlSiMg ALLOY) | MIDDLE (4 hours) | < 10 µm (CRYSTAL GRAIN INDISTINGUISHABLE) | YES | 565 - 600°C | MIDDLE (20%) | POOR |
| COMPARATIVE EXAMPLE 2 | ROLLED BODY (AlSiMg ALLOY) - ROLLED BODY (AlSiMg ALLOY) | MIDDLE (4 hours) | < 10 µm (CRYSTAL GRAIN INDISTINGUISHABLE) | YES | 610 - 630°C | LARGE (50%) | POOR |
| COMPARATIVE EXAMPLE 3 | ROLLED BODY (AlSiMg ALLOY) - ROLLED BODY (AlSiMg ALLOY) | MIDDLE (4 hours) | < 10 µm (CRYSTAL GRAIN INDISTINGUISHABLE) | YES | 575 - 610°C | MIDDLE (20%) | POOR |
| COMPARATIVE EXAMPLE 4 | ROLLED BODY (AlSiMg ALLOY) - ROLLED BODY (AlSiMg ALLOY) | MIDDLE (4 hours) | < 10 µm (CRYSTAL GRAIN INDISTINGUISHABLE) | YES | 620 - 640°C | LARGE (50%) | POOR |

### Average Diameter of Crystal Grain

The average diameter of crystal grains in the sintered body is measured mainly by optical microscope observation. The average diameter of the crystal grain was measured by selecting twenty crystal grains from a cross-sectional photograph obtained by an optical microscope and measuring the dimensions in the X-direction and the Y-direction perpendicular to the X-direction. The dimensions of the crystal grain were measured from the 10 microscopic photographs in the same manner, and the average of the dimensions of 200 crystal grains in total was obtained, and the average diameter of the 200 crystal grains was taken as the average diameter of the crystal grain.

### Liquid Phase Generation Rate at Bonding

The liquid phase generation rate can be calculated by thermodynamic calculation based on the alloy composition. The liquid phase generation rate was estimated by inputting the alloy composition of powder and the bonding process temperature into the thermodynamic equilibrium calculation software (The Chemical and Thermodynamic Equilibrium Calculator (CaTCalc) developed by Research Institute of Computational Thermodynamics Inc.).

### Bonding Quality

The quality of the bonding is evaluated by the following criteria. Very Good: Neither distortion of the bonded body nor any gap in the bonded portion was found. Good: Slight gap was found at the bonded portion but no distortion of the bonded body was found, or slight distortion was found at the bonded body but no gap was found at the bonded portion. Poor: No bonded portion was generated, or a gap was found in the bonded portion and a large distortion was found.

### Example 1

A sintered body obtained by sintering a precursor and a bonded body obtained by bonding a rolled body as an object were produced. Each of the sintered body and the rolled body was 50 mm × 50 mm × 10 mm in size. As the precursor, a powder of aluminum-silicon (AlSi) alloy (manufactured by Toyo Aluminum K.K.) was used, and the precursor was fabricated by the BJT method using the fabricating apparatus illustrated in FIG. 3. The sintering time of the precursor was four hours (middle length of time). The average diameter of the crystal grain in the sintered body was 200 µm. The rolled body obtained by melting a powder of aluminum-silicon-magnesium (AlSiMg) alloy (ALUMINUM FREE PLATES - A6061P- manufactured by MISUMI GROUP Inc.) was used. A cutting process (smoothing process) by a milling cutter was performed to each of the bonded surfaces of the sintered body and the rolled body. The bonding process temperature was set at 575°C to 610°C. The liquid phase generation rate at the time of bonding was 20 mass% (medium rate).

### Example 2

A bonded body was produced to evaluate in the same manner as in Example 1 except that the sintering time of the precursor was 2 hours (short length of time) and the average diameter of the crystal grain of the sintered body was 100 µm.

### Example 3

A bonded body was produced to evaluate in the same manner as in Example 1 except that the sintering time of the precursor was 10 hours (long length of time) and the average diameter of the crystal grain of the sintered body was 400 µm.

### Example 4

A bonded body was produced to evaluate in the same manner as in Example 1 except that the bonding process temperature was set to 620°C to 640°C and the liquid phase generation rate at the time of bonding was 50 mass% (high rate).

### Example 5

A bonded body was produced to evaluate in the same manner as in Example 1 except that a powder of copper (C1100) was used for the rolled body.

### Example 6

A bonded body was produced to evaluate in the same manner as in Example 1 except that the sintered bodies were bonded to each other instead of bonding the sintered body and the rolled body.

### Example 7

A bonded body was produced to evaluate in the same manner as in Example 6 except that the smoothing process was not performed to each bonded surface of the sintered bodies to be bonded.

### Example 8

A bonded body was produced to evaluate in the same manner as in Example 1 except that a powder of an aluminum-silicon-magnesium (AlSiMg) alloy was used as the sintered body and the bonding process temperature was set to 565°C to 600°C.

### Example 9

A bonded body was produced to evaluate in the same manner as in Example 8 except that the sintered body obtained by sintering the precursor fabricated by the MIM method that used a powder of an aluminum-silicon-magnesium (AlSiMg) alloy (manufactured by Toyo Aluminum K.K.) is used.

### Example 10

A bonded body was produced to evaluate in the same manner as in Example 1 except that a powder of an aluminum-magnesium (AlMg) alloy was used for the rolled body.

### Example 11

A sintered body obtained by sintering the precursor, a rolled body as a case, and a rolled body as a cover were bonded to each other to produce a bonded body. The size of the sintered body was 45 mm × 45 mm × 6 mm, the size (outer dimensions) of the rolled body of the case was 60 mm × 60 mm × 8 mm, and the size of the rolled body of the cover was 60 mm × 60 mm × 1.5 mm. As the precursor, a powder of aluminum-silicon (AlSi) alloy (manufactured by Toyo Aluminum K.K.) was used, and the precursor was fabricated by the BJT method using the fabricating apparatus illustrated in FIG. 3. The sintering time of the precursor was four hours (middle length of time). The average diameter of the crystal grain in the sintered body was 200 µm. The rolled body of the case was obtained by rolling a cast body obtained by melting a powder of an aluminum-silicon-magnesium (AlSiMg) alloy (ALUMINUM FREE PLATES -A6061P- manufactured by MISUMI GROUP Inc.), and the rolled body of the cover was obtained by rolling aluminum. A cutting process (smoothing process) by a milling cutter was performed to each of the bonded surfaces of the sintered body and the rolled body. The bonding process temperature was set at 575°C to 610°C. The liquid phase generation rate at the time of bonding was 20 mass% (medium rate). The sintered body and the rolled body of the case were brought into direct contact with each other, and the rolled body of the case and the rolled body of the cover were bonded by applying a brazing material. The rolled bodies were brazed to each other using a brazing material (Toyal Hyper Braze, manufactured by Toyo Aluminum K.K.).

### Example 12

A bonded body was produced to evaluate in the same manner as in Example 11 except that an aluminum rolled body was used for the case (container 7) of the rolled body, and a brazing material layer was disposed on a brazing sheet obtained by cladding an aluminum-silicon (AlSi) alloy on the surface of an aluminum-manganese (AlMn) alloy was used for the cover (cover 8).

### Example 13

A bonded body was produced to evaluate in the same manner as in Example 12 except that a pressed product of a plate material of an aluminum-manganese (AlMn) alloy was used for the case (container 7) of the rolled body.

### Example 14

A bonded body was produced to evaluate in the same manner as in Example 1 except that an alumina (Al₂O₃) plate instead of the rolled body was bonded to the sintered body.

### Example 15

A bonded body was produced to evaluate in the same manner as in Example 1 except that a silicon nitride (Si₃N₄) plate instead of the rolled body was bonded to the sintered body.

### Comparative Example 1

A bonded body was produced to evaluate in the same manner as in Example 8 except that the sintered bodies and the rolled bodies were bonded to each other instead of bonding the sintered body and the rolled body.

### Comparative Example 2

A bonded body was produced to evaluate in the same manner as in Example 1 except that the bonding process temperature was set to 610°C to 630°C and the liquid phase generation rate at the time of bonding was 50 mass% (high rate).

### Comparative Example 3

A bonded body was produced to evaluate in the same manner as in Example 1 except that the bonding process temperature was set to 575°C to 610°C.

### Comparative Example 4

A bonded body was produced to evaluate in the same manner as in Example 2 except that the bonding process temperature was set to 620°C to 640°C.

As in Examples 1 to 15 listed in Table 1, the sintered bodies obtained by sintering the precursors composed of powder containing two or more elements had an average grain diameter of 10 µm or more. The bonded bodies obtained by bonding the sintered bodies of Examples 6 and 7, the bonded bodies obtained by bonding the sintered bodies and the rolled bodies of Examples 1 to 5 and 8 to 13, and the bonded bodies obtained by bonding the sintered bodies and the ceramics of Examples 14 and 15 all had a good bonding quality.

By contrast, as in Comparative Examples 1 to 4 listed in Table 2, in the examples in which the rolled bodies were bonded to each other, the rolled bodies were not bonded, or the deformation of the rolled bodies after bonding was large, and the bonding quality was poor.

In addition, according to Table 1, in Examples 11 to 13, since the bonding by the brazing material can be performed simultaneously, the aimed bonded body can be formed in a short process.

### Aspects of the present disclosure are as follows, for example.

### First Aspect

A method of manufacturing a bonded body includes bonding a sintered body containing an alloy and an object by bringing the object into direct contact with the sintered body and performing a heating process.

### Second Aspect

In the method of manufacturing the bonded body according to the first aspect, the heating process is a process to heat the sintered body in a temperature range in which a liquid phase is generated in the sintered body.

### Third Aspect

The method of manufacturing the bonded body according to the first or second aspect further includes smoothing at least one of a bonded surface of the sintered body or a bonded surface of the object.

### Fourth Aspect

The method of manufacturing the bonded body according to any one of the first to third aspects further includes pressing the sintered body and the object in a direction in which the sintered body and the object are bonded.

### Fifth Aspect

The method of manufacturing the bonded body according to any one of the first to fourth aspects further includes sintering a precursor containing two or more elements containing at least one metal element. The precursor is fabricated by an additive manufacturing method.

### Sixth Aspect

In the method of manufacturing the bonded body according to the fifth aspect, the additive manufacturing method includes a binder jetting method.

### Seventh Aspect

In the method of manufacturing the bonded body according to any one of the first to sixth aspects, the alloy includes an aluminum alloy.

### Eighth Aspect

In the method of manufacturing the bonded body according to any one of the first to seventh aspects, the bonding has a temperature range in which a liquid phase having 5 mass% or more and 50 mass% or less is generated in the sintered body.

### Ninth Aspect

In the method of manufacturing the boded body according to any one of the first to eighth aspects, the sintered body includes: a eutectic portion containing aluminum; and a crystal grain containing aluminum and silicon and being surrounded by the eutectic portion.

### Tenth Aspect

In the method of manufacturing the bonded body according to any one of the first to ninth aspects, the object has a melting point equal to or higher than the sintered body.

### Eleventh Aspect

In the method of manufacturing the bonded body according to any one of the first to tenth aspects, the sintered body is bonded to a brazing member in a region different from a region in which the sintered body is bonded to the object by the heating process of the bonding.

### Twelfth Aspect

In the method of manufacturing the bonded body according to any one of the first to tenth aspects, a region of the object is bonded to another region of the object in a region different from a region in which sintered body is bonded to the object by the heating process of the bonding.

### Thirteenth Aspect

A bonded body includes a sintered body and an object directly bonded to the sintered body. The sintered body includes an alloy and a crystal grain surrounded by a eutectic portion. The alloy contains two or more elements. The crystal grain has an average diameter of 10 µm or more.

### Fourteenth Aspect

In the bonded body according to the thirteenth aspect, the crystal grain has an average diameter of 10 µm or more and 500 µm or less.

### Fifteenth Aspect

In the bonded body according to the thirteenth or fourteenth aspect, the alloy includes an aluminum alloy.

### Sixteenth Aspect

In the bonded body according to any one of the thirteenth to fifteenth aspects, the sintered body is included in a case including at least the object.

### Seventeenth Aspect

A heat sink includes the bonded body according to any one of the thirteenth to sixteenth aspects.

The above-described embodiments are illustrative and do not limit the present invention. Thus, numerous additional modifications and variations are possible in light of the above teachings. For example, elements and/or features of different illustrative embodiments may be combined with each other and/or substituted for each other within the scope of the present invention. Any one of the above-described operations may be performed in various other ways, for example, in an order different from the one described above.

The functionality of the elements disclosed herein may be implemented using circuitry or processing circuitry which includes general purpose processors, special purpose processors, integrated circuits, ASICs ("Application Specific Integrated Circuits"), FPGAs ("Field-Programmable Gate Arrays"), and/or combinations thereof which are configured or programmed, using one or more programs stored in one or more memories, to perform the disclosed functionality. Processors are considered processing circuitry or circuitry as they include transistors and other circuitry therein. In the disclosure, the circuitry, units, or means are hardware that carry out or are programmed to perform the recited functionality. The hardware may be any hardware disclosed herein which is programmed or configured to carry out the recited functionality.

## Claims

1. A method of manufacturing a bonded body comprising
heating a sintered body (3) while the sintered body (3) is in direct contact with an object (4) to bond the object with the sintered body (3) to obtain the bonded body.

2. The method of manufacturing the bonded body according to claim 1,
wherein the heating heats the sintered body (3) at a temperature range in which a liquid phase is generated in the sintered body (3).

3. The method of manufacturing the bonded body according to claim 1 or 2, further comprising:
smoothing (S11) at least one of a bonding surface of the sintered body or a bonding surface of the object before bonding the sintered body to the object.

4. The method of manufacturing the bonded body according to any one of claims 1 to 3, further comprising:
pressing (S12) the sintered body and the object in a bonding direction before or during bonding the sintered body to the object.

5. The method of manufacturing the bonded body according to any one of claims 1 to 4, further comprising:
fabricating a precursor containing two or more elements containing at least one metal element by an additive manufacturing method; and
sintering (S1) the precursor containing two or more elements containing at least one metal element to obtain the sintered body before bonding the sintered body to the object.

6. The method of manufacturing the bonded body according to claim 5, wherein the additive manufacturing method includes a binder jetting method.

7. The method of manufacturing the bonded body according to any one of claims 1 to 6,
wherein the heating heats the sintered body (3) containing an aluminum alloy.

8. The method of manufacturing the bonded body according to claim 2,
wherein the heating heats the sintered body with a temperature range in which a liquid phase having 5 mass% or more and 50 mass% or less is generated in the sintered body.

9. The method of manufacturing the bonded body according to claim 7,
wherein the heating heats the sintered body (3) including:
a eutectic portion (E) containing aluminum and silicon; and
a crystal grain (C) containing aluminum, the crystal grain surrounded by the eutectic portion.

10. The method of manufacturing the bonded body according to any one of claims 1 to 9,
wherein the heating heats the object having a melting point equal to or higher than the sintered body.

11. The method of manufacturing the bonded body according to any one of claims 1 to 10,
wherein the heating bonds the sintered body to a brazing member in a region different from a region in which the sintered body is bonded to the object by the heating.

12. The method of manufacturing the bonded body according to any one of claims 1 to 11,
wherein the heating bonds a region of the object to another region of the object in a region different from a region in which the sintered body is bonded to the object by the heating.

13. A bonded body comprising:
a sintered body including:
an alloy; and
a crystal grain surrounded by a eutectic portion, the crystal grain having an average diameter of 10 µm or more; and
an object to be directly bonded to the sintered body.

14. The bonded body according to claim 13, further comprising:
a case including at least the object, the case accommodates the sintered body.

15. A heat sink comprising the bonded body according to claim 13 or 14.
